# EUROPEAN PATENT APPLICATION

(11) **EP 4 471 555 A1**
(43) Date of publication of application: **04.12.2024**
(21) Application number: 22968117.6
(22) Date of filing: 13.12.2022
(51) Int. Cl.: G06F 3/044

(54) **TOUCH SENSOR AND TOUCH SENSING DEVICE COMPRISING SAME, AND EARPHONES**

(71) Applicant: Shenzhen Shokz Co., Ltd., Shenzhen, Guangdong 518108 (CN)
(72) Inventor: YUAN, Yongshuai, Shenzhen, Guangdong 518108 (CN)
(74) Representative: Wang, Bo
(86) International application number: PCT/CN2022/138748
(87) International publication number: WO 2024/124404

(57) **Abstract**

Embodiments of the present disclosure relate to a touch sensor. The touch sensor includes: a substrate; a first electrode and a second electrode, the first electrode being disposed on the substrate; and an elastic layer disposed on the first electrode or the substrate, the second electrode being disposed on the elastic layer. When the elastic layer is in a natural state, the first electrode and the second electrode are not in contact, and the touch sensor is in a disconnected state; and when a user applies a pressure to the touch sensor, the elastic layer deforms, the first electrode comes into contact with the second electrode, and the touch sensor switches from the disconnected state to a connected state and generates an electrical signal.

## Description

### TECHNICAL FIELD

The present disclosure relates to the field of sensors, and in particular to a touch sensor.

### BACKGROUND

Touch sensing, as an important human-computer interaction manner, is widely applied in a variety of electronic products, especially in wearable devices such as recently emerged true wireless stereo (TWS) earphones. However, there are many problems with existing touch sensors, such as being susceptible to interference by sweat, impurities, or human movement, and not being sensitive enough.

Therefore, it is necessary to design a touch sensor whose sensitivity performance meets the demands and is not easily interfered with by factors such as sweat, impurities, and human movement.

### SUMMARY

Embodiments of the present disclosure may provide a touch sensor includes a substrate; a first electrode and a second electrode, the first electrode being disposed on the substrate; and an elastic layer disposed on the first electrode or the substrate, the second electrode being disposed on the elastic layer. When the elastic layer is in a natural state, the first electrode and the second electrode are not in contact, and the touch sensor is in a disconnected state; and when a user applies a pressure to the touch sensor, the elastic layer deforms, the first electrode comes into contact with the second electrode, and the touch sensor switches from the disconnected state to a connected state and generates an electrical signal.

In some embodiments, a distance between the first electrode and the second electrode is in a range of 50 nm-1 mm when the elastic layer is in the natural state.

In some embodiments, in a deformation direction of the elastic layer, a thickness of the touch sensor is no more than 1 mm.

In some embodiments, in a deformation direction of the elastic layer, projections of the first electrode and the second electrode have an overlapping region, and at least a portion of the overlapping region is not covered by the elastic layer.

In some embodiments, the first electrode is an integral electrode.

In some embodiments, the first electrode includes two or more sub-electrodes spaced apart from each other.

In some embodiments, a thickness of the elastic layer in the natural state is in a range of 50 nm-1 mm, and an elastic coefficient of the elastic layer is in a range of 200 GPa⁻¹ kPa.

In some embodiments, the touch sensor further includes a protective layer for encapsulating the substrate, the first electrode, the second electrode, and the elastic layer.

Embodiments of the present disclosure may also provide a touch sensing device including: two or more touch sensors, each touch sensor is configured to switch from a disconnected state to a connected state to generate an electrical signal in response to a pressure applied by a user; a power supply assembly configured to supply power to the two or more touch sensors; and a processor configured to determine a touch gesture of the user based on at least one electrical signal corresponding to the two or more touch sensors. Each touch sensor includes: a substrate; a first electrode and a second electrode. The first electrode is disposed on the substrate; and an elastic layer disposed on the first electrode or the substrate, the second electrode being disposed on the elastic layer. When the elastic layer is in a natural state, the first electrode and the second electrode are not in contact, and the touch sensor is in the disconnected state. When the user applies the pressure to the touch sensor, the elastic layer deforms, the first electrode comes into contact with the second electrode, and the touch sensor switches from the disconnected state to the connected state and generates the electrical signal.

In some embodiments, the touch gesture includes a tap gesture, a long press gesture, or a slide gesture.

In some embodiments, the at least one electrical signal corresponding to the two or more touch sensors includes the electrical signal corresponding to each touch sensor, and the determining the touch gesture of the user based on the at least one electrical signal corresponding to the two or more touch sensors includes: determining the slide gesture and a slide direction of the user based on a position of each touch sensor and a signal time of the electrical signal corresponding to each touch sensor.

In some embodiments, the at least one electrical signal corresponding to the two or more touch sensors includes a composite signal of the electrical signals of the two or more touch sensors, and the determining the touch gesture of the user based on the at least one electrical signal corresponding to the two or more touch sensors includes: determining the slide gesture and a slide direction of the user based on an amplitude of the composite signal.

In some embodiments, the two or more touch sensors are disposed in parallel in a detection circuit, and each touch sensor corresponds to a detection sub-circuit. A resistance value of a resistor set in the detection sub-circuit corresponding to each touch sensor is different, conductivities of the first electrode and the second electrode corresponding to different detection sub-circuits are different, or different detection sub-circuits correspond to different supply voltages.

Embodiments of the present disclosure may also provide an earphone including: a speaker configured to generate a sound signal; at least one touch sensor; and a housing for carrying the speaker and the at least one touch sensor. Each touch sensor includes: a substrate; a first electrode and a second electrode. The first electrode is disposed on the substrate; and an elastic layer disposed on the first electrode or the substrate. The second electrode is disposed on the elastic layer. When the elastic layer is in a natural state, the first electrode and the second electrode are not in contact, and the touch sensor is in the disconnected state; when the user applies a pressure to the touch sensor, the elastic layer deforms, the first electrode comes into contact with the second electrode, and the touch sensor switches from the disconnected state to a connected state and generates an electrical signal.

In some embodiments, the housing includes a contact surface, when a user is wearing the earphone, the contact surface is configured to come into contact with the user's face, and at least a portion of the at least one touch sensor is disposed on the contact surface.

### BRIEF DESCRIPTION OF THE DRAWINGS

The present disclosure will be further illustrated by way of exemplary embodiments, which will be described in detail by means of the accompanying drawings. These embodiments are not limiting, and in these embodiments, the same numbering denotes the same structure, wherein:
FIG. 1 is a block diagram illustrating an exemplary touch sensor according to some embodiments of the present disclosure;
FIG. 2A is a schematic diagram illustrating a structure of an exemplary touch sensor in a disconnected state according to some embodiments of the present disclosure;
FIG. 2B is a schematic diagram illustrating a structure of an exemplary touch sensor in a connected state according to some embodiments of the present disclosure;
FIG. 3A is a schematic diagram illustrating a structure of an exemplary touch sensor in a disconnected state according to some other embodiments of the present disclosure;
FIG. 3B is a schematic diagram illustrating a structure of an exemplary touch sensor in a connected state according to some other embodiments of the present disclosure;
FIG. 4A is a schematic diagram illustrating a structure of an exemplary touch sensor in a disconnected state according to other embodiments of the present disclosure;
FIG. 4B is a schematic diagram illustrating a structure of an exemplary touch sensor in a connected state according to some other embodiments of the present disclosure;
FIG. 5A is a schematic diagram illustrating a structure of an exemplary touch sensor in a disconnected state according to some other embodiments of the present disclosure;
FIG. 5B is a schematic diagram illustrating a structure of an exemplary touch sensor in a connected state according to some other embodiments of the present disclosure;
FIG. 6A is a schematic diagram illustrating a structure of an exemplary touch sensor in a disconnected state according to some other embodiments of the present disclosure;
FIG. 6B is a schematic diagram illustrating a structure of an exemplary touch sensor in a connected state according to some other embodiments of the present disclosure;
FIG. 7A is a top view illustrating an exemplary touch sensor according to some embodiments of the present disclosure;
FIG. 7B is a top view illustrating an exemplary touch sensor according to some other embodiments of the present disclosure;
FIG. 8A is a top view illustrating an exemplary touch sensor according to some other embodiments of the present disclosure;
FIG. 8B is a top view illustrating an exemplary touch sensor according to some other embodiments of the present disclosure;
FIG. 9 is a block diagram illustrating a structure of an exemplary touch sensing device according to some embodiments of the present disclosure;
FIG. 10A is a schematic diagram illustrating a state of an exemplary touch sensing device when a slide gesture slides to the right according to some embodiments of the present disclosure;
FIG. 10B is a schematic diagram illustrating a state of an exemplary touch sensing device when a slide gesture slides to the left according to some embodiments of the present disclosure;
FIG. 11A is a schematic diagram illustrating an exemplary touch detection circuit of a touch sensing device according to some embodiments of the present disclosure;
FIG. 11B is an electrical signal detected by the touch detection circuit in FIG.11A;
FIG. 12A is a schematic diagram illustrating an exemplary touch detection circuit of a touch sensing device according to some embodiments of the present disclosure;
FIG. 12B is an electrical signal detected by the touch detection circuit in FIG. 12A; and
FIG. 13 is a block diagram illustrating a structure of an exemplary earphone according to some embodiments of the present disclosure.

### DETAILED DESCRIPTION

To more clearly illustrate the technical solutions of the embodiments of the present disclosure, the accompanying drawings required to be used in the description of the embodiments are briefly described below. Obviously, the accompanying drawings in the following description are only some examples or embodiments of the present disclosure, and it is possible for those skilled in the art to apply the present disclosure to other similar scenarios based on the accompanying drawings without creative labor. Unless obviously obtained from the context or the context illustrates otherwise, the same numeral in the drawings refers to the same structure or operation.

It should be understood that as used herein, the terms "system," "device," "unit" and/or "module" as used herein is a way to distinguish between different components, elements, parts, sections or assemblies at different levels. However, words may be replaced by other expressions if other words accomplish the same purpose.

As used in the disclosure and the appended claims, the singular forms "a," "an," and "the" include plural referents unless the content clearly dictates otherwise. In general, the terms "including" and "comprising" suggest only the inclusion of clearly identified steps and elements, which do not constitute an exclusive list, and the method or device may also include other steps or elements. The term "based on" is "at least partly based on." The term "one embodiment" means "at least one embodiment"; the term "another embodiment" means "at least one other embodiment".

In the description of the present disclosure, it is to be understood that the terms "first," "second," "third," "fourth," etc., are used for descriptive purposes only, and are not to be understood as indicating or implying relative importance or implicitly specifying the number of technical features indicated. Thereby, the limitations "first," "second," "third," "fourth" may expressly or implicitly include at least one such feature. In the description of the present disclosure, "plurality" means at least two, e.g., two, three, etc., unless otherwise expressly and specifically limited.

In the present disclosure, unless otherwise expressly specified or limited, the terms "connection," "fixing," etc., shall be construed broadly unless otherwise expressly provided and qualified. For example, the term "connection" may refer to a fixed connection, a removable connection, or a one-piece connection; may be a mechanical connection, or an electrical connection; may be a direct connection, or an indirect connection through an intermediate medium, a connection within two elements, or an interaction between two elements, unless expressly limited otherwise. To those skilled in the art, the specific meaning of the above terms in the present disclosure may be understood on a case-by-case basis.

Embodiments of the present disclosure provide a touch sensor including a substrate, a first electrode, a second electrode, and an elastic layer. The first electrode may be provided on the substrate. The elastic layer may be provided on the first electrode or the substrate, and the second electrode is provided on the elastic layer. When the elastic layer is in a natural state, the first electrode and the second electrode are not in contact, and the touch sensor is in a disconnected state. When a user applies a pressure to the touch sensor, the elastic layer deforms, and the first electrode comes into contact with the second electrode, the touch sensor switches from the disconnected state to a connected state and generates an electrical signal.

In the embodiments of the present disclosure, by providing the elastic layer that cooperates with the first electrode and the second electrode, the touch sensor is in a disconnected state when not subjected to external pressure, and in a connected state when subjected to the external pressure. Further, based on a difference in signals generated by the touch sensor when it is in the disconnected state and the connected state, whether or not the user applies pressure (e.g., whether or not the user taps or long presses) is determined, which in turn allows for the execution of a corresponding operation (e.g., activate or close an application program). The touch sensor is not easily interfered by a human body capacitance, sweat, a temperature, a human body movement, etc., and is highly stable. Additionally, by adjusting a distance between the first electrode and the second electrode when the elastic layer is in the natural state, the sensitivity of the touch sensor may be adjusted to satisfy various sensitivity demands.

Embodiments of the present disclosure also provide a touch sensing device including two or more touch sensors, a power supply assembly, and a processor. By combining the two or more touch sensors described above, and based on a change rule between the sensing signals of the touch sensors, a touch gesture of the user may be accurately determined. The structure of the touch sensor is simple which can improve the stability of the touch sensing device and make it less susceptible to the interference by the human capacitance, the sweat, the temperature, and the human movement, etc.

Embodiments of the present disclosure also provide an earphone including a speaker, at least one touch sensor, and a housing. The housing includes a contact surface. The contact surface is configured to come into contact with the user's face when the user is wearing the earphone, and at least a portion of the at least one touch sensor is provided on the contact surface. By contacting or separating the first electrode and the second electrode in the touch sensor, a current state (e.g., a wearing or non-wearing state) of the earphone is determined, thereby further adjusting an operation state of one or more electronic components (e.g., a Bluetooth module, a battery, etc.) of the earphone based on the current state of the earphone.

The touch sensor, the touch sensing device, and the earphone provided by embodiments of the present disclosure are described in detail below in connection with the accompanying drawings.

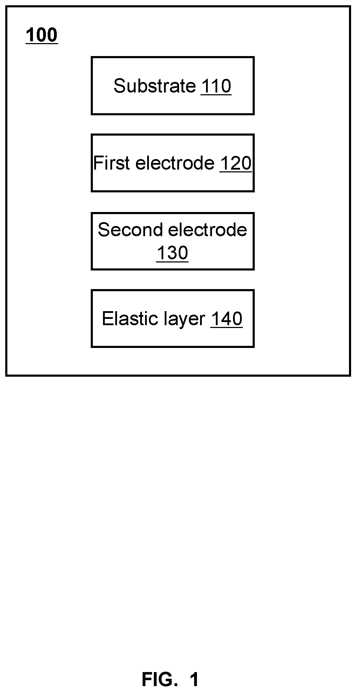

FIG. 1 is a block diagram illustrating an exemplary touch sensor according to some embodiments of the present disclosure. As shown in FIG. 1, a touch sensor 100 may include a substrate 110, a first electrode 120, a second electrode 130, and an elastic layer 140.

The substrate 110 may serve as a mounting base to provide a supportive mounting platform for other components of the touch sensor 100 (e.g., the first electrode 120, the second electrode 130, the elastic layer 140, etc.). In some embodiments, the substrate 110 may be a substrate layer in the touch sensor prepared by a process based on micro-electromechanical systems (MEMS). An electrode layer may be deposited on the substrate layer for subsequent preparation. In some embodiments, a material of the substrate 110 may include, but is not limited to, a thermoplastic polyurethane rubber (TPU), ethylene vinyl acetate copolymer (EVA), polydimethylsiloxane (PDMS), Ecoflex, resins, silicone-based polymeric materials, etc.

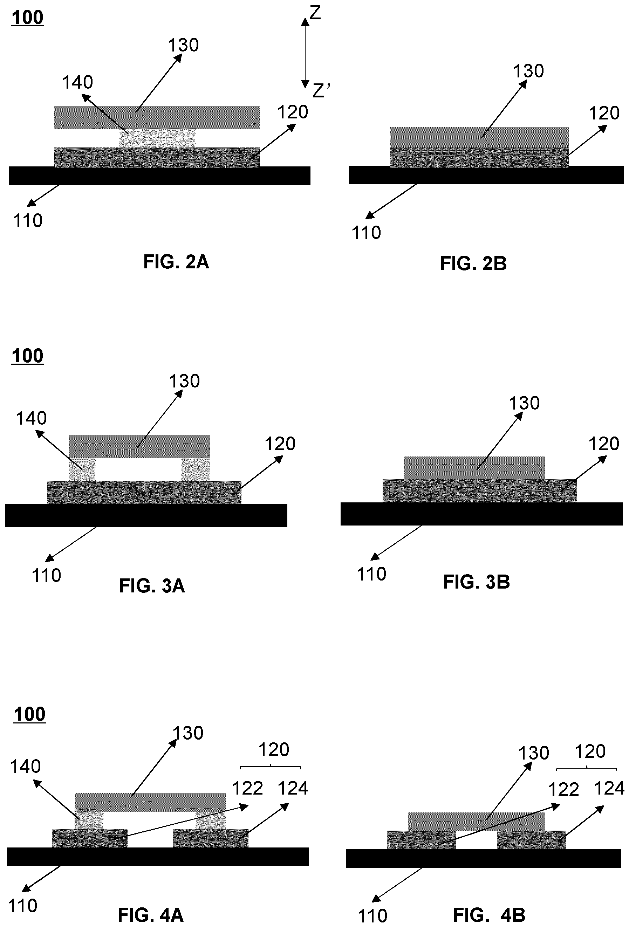

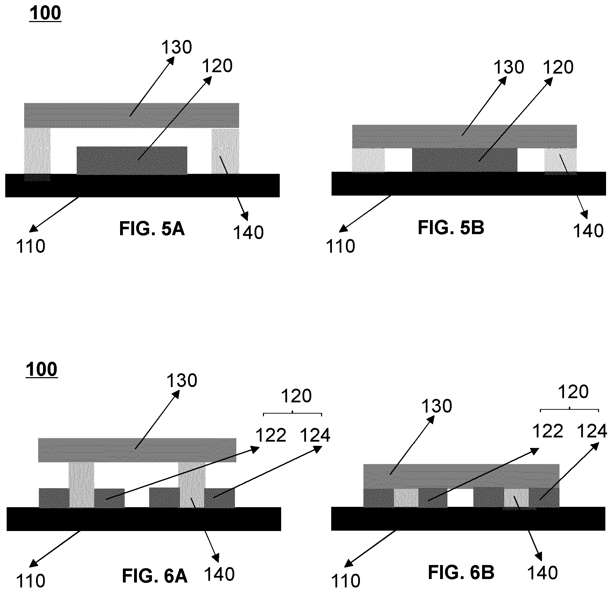

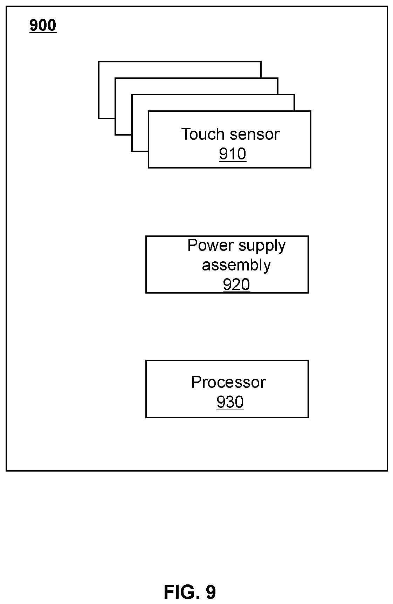

The first electrode 120 may be provided or disposed on the substrate 110. For example, the first electrode 120 may be directly affixed to the substrate 110. For another example, the first electrode 120 may be an electrode layer deposited on the substrate 110. The elastic layer 140 may be provided or disposed on the first electrode 120 or the substrate 110 (as shown in FIG. 2A or FIG. 5A). The second electrode 130 may be provided on the elastic layer 140. The elastic layer 140 may support the second electrode 130 so that the second electrode 130 does not contact the first electrode 120 when the touch sensor 100 is not subjected to an external pressure (i.e., when the elastic layer 140 is in a natural state), so that the touch sensor 100 is in a disconnected state (which may be referred to as the touch sensor 100 being in a disconnected state) in the circuit. In the embodiments of the present disclosure, the natural state refers to a state of the elastic layer 140 when the touch sensor 100 is not subjected to the external pressure. When the user applies a pressure to the touch sensor 100, the pressure is conducted to the elastic layer 140 through the second electrode 130, causing the elastic layer 140 to deform further, resulting in contact between the second electrode 130 and the first electrode 120, so that the touch sensor 100 switches from the disconnected state to the connected state (which is referred to as the touch sensor 100 being in the connected state) and generates an electrical signal. When the pressure applied by the user is withdrawn, the elastic layer 140 restores to the natural state, which causes the second electrode 130 and the first electrode 120 to be separated, and in turn causes the touch sensor 100 to switch from the connected state to the disconnected state. Thus, whether the user applies pressure (e.g., whether the user taps or long presses) may be determined based on a difference between the electrical signals generated in the connected state and the disconnected state of the touch sensor 100 in the circuit, and thus a corresponding operation may be performed. For example, the touch sensor 100 may be used as a touch or click button for activating or closing an application program. For another example, the touch sensor 100 may be used as an appliance switch to achieve a structure surface without bumps, or to hide the switch. Further, a user's touch gesture may be determined through a change in signal between two or more touch sensors 100. For more content on the determination of the touch gesture, please refer to elsewhere in the present disclosure, e.g., in the descriptions of FIG. 9, FIGs.10A-10B, FIGs.11A-11B, and FIGs.12A-12B, which are not repeated here.

It is to be known that to make the contact between the first electrode 120 and the second electrode 130 after the elastic layer 140 is compressed by the external pressure, projections of the first electrode 120 and the second electrode 130 in the direction of deformation (also referred to as a deformation direction) of the elastic layer 140 has an overlapping region, and at least a portion of the overlapping region is not covered by the elastic layer 140. In addition, in the deformation direction of the elastic layer 140, a projection area of the first electrode 120 or a projection area of the second electrode 130 may be greater than, smaller than, or equal to a projection area of the elastic layer 140, which is not limited in the present disclosure. There may be one or more elastic layers 140, a number of which is not limited in the present disclosure.

In some embodiments, the first electrode 120 may be an integral electrode (as shown in FIG. 2A) or may include two or more spaced apart sub-electrodes (as shown in FIG. 4A). In some embodiments, the touch sensor 100 further includes electrode leads to connect the touch sensor 100 to a touch detection circuit. When the first electrode 120 is an integral electrode, the touch sensor 100 may include two electrode leads leading from the first electrode 120 and the second electrode 130, respectively, to make sure that the touch sensor 100 is in the disconnected state when the elastic layer 140 is in the natural state, and make the touch sensor 100 in the connected state when the elastic layer 140 is compressed. In some embodiments, when the first electrode 120 includes two or more spaced apart sub-electrodes, the touch sensor 100 may lead two or more electrode leads from at least two of the two or more sub-electrodes, respectively, or lead two electrode leads from at least one of the sub-electrodes and the second electrode 130. In a situation where the two sub-electrodes lead to the electrode leads respectively, the second electrode 130 may electrically conduct the two sub-electrodes when the elastic layer 140 is compressed, leaving the two sub-electrodes in the connected state to generate the electrical signal.

In some embodiments, materials of the first electrode 120 and the second electrode 130 may be the same or different. In some embodiments, the material of the first electrode 120 and/or the second electrode 130 may be an electrically conductive material such as a metal, a graphite, an electrically conductive cloth, an electrically conductive silver plasma coating, a metal plating, etc. The selection of the material of the elastic layer 140 needs to ensure that the first electrode 120 and the second electrode 130 do not come into contact when the elastic layer 140 is in the natural state, and that the deformation occurs relatively easily after being subjected to a pressure, and that the elastic layer 140 restores quickly to the natural state after unloading the pressure. In some embodiments, the elastic layer 140 may include foam, polydimethylsiloxane (PDMS), polyimide (PI), thermoplastic polyurethane elastomer (TPU), silicone, rubber, and other flexible materials. In some embodiments, in a situation where the distance between the first electrode 120 and the second electrode 130 is sufficiently small when the elastic layer 140 is in the natural state, the elastic layer 140 may also include a rigid material with relatively high rigidity. In some embodiments, the elastic layer 140 may be suitably structured to achieve an elastic deformation, for example, the elastic layer 140 may be a spring structure supported between the first electrode 120 and the second electrode 130, or a suspended film structure or a reed structure that suspends the second electrode 130 opposite to the first electrode 120, etc.

It is to be known that when the distance between the first electrode 120 and the second electrode 130 is sufficiently small, the elastic layer 140 requires only a small deformation to bring the first electrode 120 and the second electrode 130 into contact, at which time an elastic coefficient of the material of the elastic layer 140 may be greater, for example, close to an elastic coefficient of a rigid material. When the distance between the first electrode 120 and the second electrode 130 is greater, then the elastic layer 140 requires a greater deformation to make contact between the first electrode 120 and the second electrode 130, and the elastic coefficient of the material of the elastic layer 140 may be smaller. In some embodiments, the elastic coefficient of the material of the elastic layer 140 may be negatively correlated with a thickness of the elastic layer 140 in the natural state. The greater the thickness of the elastic layer 140, the greater the distance between the two electrodes (i.e., the first electrode 120 and the second electrode 130), the smaller the elastic coefficient of the elastic layer, so as to bring the second electrode 130 into contact with the first electrode 120 under a smaller external force. In some embodiments, the thickness of the elastic layer 140 in the natural state may be in a range of 50 nm-1 mm, and the elastic coefficient of the elastic layer 140 may be in a range of 1 kPa-200 GPa.

An operation principle of the touch sensor 100 is that when subjected to the external pressure, the elastic layer 140 undergoes deformation to cause the first electrode 120 to contact the second electrode 130 to generate the electrical signal. Therefore, when the touch sensor 100 is not subjected to the external pressure, the distance between the first electrode 120 and the second electrode 130 may affect the sensitivity of the touch sensor 100. The smaller the distance between the first electrode 120 and the second electrode 130 when the elastic layer 140 is in the natural state, the higher the sensitivity of the touch sensor 100. Thus, the sensitivity of the touch sensor 100 may be adjusted by setting the distance between the first electrode 120 and the second electrode 130 to meet the demands of different sensitivities. In some embodiments, when the elastic layer 140 is in the natural state, the distance between the first electrode 120 and the second electrode 130 may be in a range of 50 nm-1 mm.

In some embodiments, due to the simple structure of the touch sensor 100, a size of the touch sensor 100 is mainly determined by the distance between the first electrode 120 and the second electrode 130 when the elastic layer 140 is in the natural state, and thus it is possible for the touch sensor 100 to have a smaller size to satisfy the demand for miniaturization of the device. For example, the thickness of the touch sensor 100 may be no greater than 1 mm along the deformation direction of the elastic layer 140.

In some embodiments, the touch sensor 100 may also include a protective layer (not shown in the figures). The protective layer may be used to encapsulate the substrate 110, the first electrode 120, the second electrode 130, and the elastic layer 140 to protect the first electrode 120 and the second electrode 130, and avoid the first electrode 120, the second electrode 130 and/or the elastic layer 140 from falling off, thereby further improving the stability and the mechanical reliability of the touch sensor 100. In some embodiments, the protective layer may include a flexible insulating film, the material of which may include the insulating polyimide (Polyimide, PI), the thermoplastic polyurethane elastomer (TPU), the silicone, polyvinyl chloride (PVC), and other insulating resin materials. In some embodiments, the protective layer may also include the rigid material such as a metal, a silicon, etc.

Through the action of an external force on the elastic layer 140 to cause the first electrode 120 and the second electrode 130 to come into contact or separate, the touch sensor 100 described in some embodiments of the present disclosure can switch its connected state or disconnected state. In this way, a simple structure, low production cost, and a high stability may be achieved, thereby conducive to commercialization.

FIG. 2A and FIG. 2B are schematic diagrams illustrating a structure of an exemplary touch sensor in a disconnected state and a connected state, respectively according to some embodiments of the present disclosure.

As shown in FIG. 2A and FIG. 2B, the first electrode 120 may be an integral electrode. The touch sensor 100 may include only one elastic layer 140. The elastic layer 140 may be disposed at any position on the first electrode 120 (e.g., a center or an edge position). The second electrode 130 is disposed on the elastic layer 140. Along the deformation direction of the elastic layer 140 (i.e., the ZZ' direction in FIG. 2A), projection areas of the first electrode 120 and the second electrode 130 may both be greater than the projection area of the elastic layer 140 to ensure that there is a contact surface between the first electrode 120 and the second electrode 130 when the elastic layer 140 is compressed.

Further, the touch sensor 100 may also include electrode leads (not shown) to enable the touch sensor 100 to be connected to a circuit so that an electrical signal generated by the touch sensor 100 can be output. Specifically, each of the first electrode 120 and the second electrode 130 may be connected to an electrode lead. When the elastic layer 140 is in a natural state, the second electrode 130 and the first electrode 120 are not in contact, leaving the touch sensor 100 in the disconnected state, as shown in FIG. 2A. When the touch sensor 100 is subjected to an external pressure (e.g., a user taps the second electrode 130), the elastic layer 140 may deform and be compressed. At this time, as the projections of the first electrode 120 and the second electrode 130 along the deformation direction of the elastic layer 140 have an overlapping region and at least a portion of the overlapping region is not covered by the elastic layer 140, the second electrode 130 may be in contact with the first electrode 120, leaving the touch sensor 100 in the connected state, as shown in FIG. 2B.

FIG. 3A and FIG. 3B are schematic diagrams illustrating a structure of an exemplary touch sensor in a disconnected state and a connected state, respectively according to some other embodiments of the present disclosure.

The first electrode 120 may be an integral electrode, as shown in FIGs. 3A and 3B. The touch sensor 100 may include at least two elastic layers 140. The at least two elastic layers 140 may be uniformly or non-uniformly disposed on the first electrode 120. For example, the at least two elastic layers 140 may be equally spaced on the first electrode 120. For another example, one of the elastic layers 140 may be disposed at a center of the first electrode 120, and the remaining elastic layers 140 may be disposed at any edge position of the first electrode 120. The second electrode 130 is provided on the elastic layer 140. Along a deformation direction of the elastic layer 140, projection areas of the first electrode 120 and the second electrode 130 may both be greater than the projection area of the elastic layer 140 to ensure that the first electrode 120 and the second electrode 130 have a contact surface between them after the elastic layer 140 is compressed.

Further, the touch sensor 100 may also include electrode leads (not shown) to enable the touch sensor 100 to be connected to a circuit so that an electrical signal generated by the touch sensor 100 can be output. Specifically, each of the first electrode 120 and the second electrode 130 may be connected to an electrode lead. When the elastic layer 140 is in a natural state, the second electrode 130 and the first electrode 120 are not in contact, leaving the touch sensor 100 in a connected state, as shown in FIG. 3A. When the touch sensor 100 is subjected to an external pressure (e.g., a user taps the second electrode 130), the elastic layer 140 may deform and be compressed. At this time, as the projections of the first electrode 120 and the second electrode 130 along the deformation direction of the elastic layer 140 have an overlapping region and at least a portion of the overlapping region is not covered by the elastic layer 140, the second electrode 130 may be in contact with the first electrode 120, leaving the touch sensor 100 in the connected state, as shown in FIG. 3B.

FIG. 4A and FIG. 4B are schematic diagrams illustrating a structure of an exemplary touch sensor in a disconnected state and a connected state, respectively according to some other embodiments of the present disclosure.

The first electrode 120 may include a sub-electrode 122 and a sub-electrode 124 as shown in FIG. 4A and FIG. 4B. The touch sensor 100 may include two elastic layers 140. One elastic layer 140 may be disposed on each of the sub-electrodes. Each elastic layer 140 may be connected to one end of the second electrode 130, respectively, thereby supporting the second electrode 130. In some embodiments, the touch sensor 100 may include only one elastic layer 140. This elastic layer 140 may be disposed between the sub-electrode 122 and the sub-electrode 124 and provided on the substrate 110 to support the second electrode 130. Along a deformation direction of the elastic layer 140, projection areas of the second electrode 130 and the sub-electrode 122 and/or the sub-electrode 124 may both be greater than the projection area of the elastic layer 140 to ensure that there is a contact surface between the first electrode 120 and the second electrode 130 after the elastic layer 140 is compressed.

Further, the touch sensor 100 may also include electrode leads (not shown) to enable the touch sensor 100 to be connected to a circuit so that an electrical signal generated by the touch sensor 100 can be output. Specifically, in some embodiments, the sub-electrode 122 (or the sub-electrode 124) and the second electrode 130 may each be connected to an electrode lead. When the elastic layer 140 is in a natural state, the touch sensor 100 is in the disconnected state, and the two electrode leads are not conductive to each other. When the elastic layer 140 is compressed, the touch sensor 100 is in the connected state, and a conduction loop is formed between the two electrode leads. In some embodiments, the sub-electrode 122 and the sub-electrode 124 may each be connected to an electrode lead. When the elastic layer 140 is in the natural state, the second electrode 130 and the first electrode 120 are not in contact, leaving the touch sensor 100 in the disconnected state, as shown in FIG. 4A. When the touch sensor 100 is subjected to an external pressure (e.g., a user taps the second electrode 130), the elastic layer 140 may deform and be compressed. At this time, as the projections of the first electrode 120 and the second electrode 130 along the deformation direction of the elastic layer 140 have an overlapping region and at least a portion of the overlapping region is not covered by the elastic layer 140, the second electrode 130 may be in contact with the first electrode 120, and the sub-electrode 122 and the sub-electrode 124 may be conductive to each other via the second electrode 130, so that the touch sensor 100 is in the connected state, as shown in FIG. 4B.

FIG. 5A and FIG. 5B are schematic diagrams illustrating a structure of an exemplary touch sensor in a disconnected state and a connected state, respectively according to some other embodiments of the present disclosure.

As shown in FIG. 5A and FIG. 5B, the first electrode 120 may be an integral electrode. The touch sensor 100 may include at least two elastic layers 140. In some embodiments, the at least two elastic layers 140 may be uniformly or non-uniformly disposed on the substrate 110. For example, the at least two elastic layers 140 may be equally spaced on the substrate 110 and surround the first electrode 120. For another example, the same or different count of elastic layers 140 may be provided on a substrate region near two ends of the first electrode 120. Along the deformation direction of the elastic layer 140, a projection area of the second electrode 130 may be greater than the projection area of the first electrode 120 to ensure that there is a contact surface between the first electrode 120 and the second electrode 130 after the elastic layer 140 is compressed.

Further, the touch sensor 100 may also include electrode leads (not shown) to enable the touch sensor 100 to be connected to a circuit so that an electrical signal generated by the touch sensor 100 can be output. Specifically, the first electrode 120 and the second electrode 130 may each be connected to an electrode lead to enable the touch sensor 100 to be in the disconnected state when the elastic layer 140 is in a natural state and to enable the touch sensor 100 to be in the connected state when the elastic layer 140 is compressed. When the elastic layer 140 is in the natural state, the second electrode 130 and the first electrode 120 are not in contact, causing the touch sensor 100 to be in the disconnected state, as shown in FIG. 5A. When the touch sensor 100 is subjected to an external pressure (e.g., a user taps the second electrode 130), the elastic layer 140 may deform and be compressed. At this time, as the projection of the first electrode 120 in the deformation direction of the elastic layer 140 is able to completely cover the projection of the second electrode 130 and there is no elastic layers 140 between the contact surfaces, the second electrode 130 may be in contact with the first electrode 120, causing the touch sensor 100 to be in the connected state, as shown in FIG. 5B.

By setting the elastic layer 140 on the substrate 110, the touch sensor described in some embodiments of the present disclosure may enhance contact stability between the first electrode 120 and the second electrode 130 when the touch sensor 100 is in the connected state. As a result, the touch sensor 100 is more sensitive, and at the same time, the service life of the touch sensor 100 is extended.

FIG. 6A and FIG. 6B are schematic diagrams illustrating a structure of an exemplary touch sensor in a disconnected state and a connected state, respectively according to some other embodiments of the present disclosure.

As shown in FIG. 6A and FIG. 6B, the first electrode 120 may include the sub-electrode 122 and the sub-electrode 124 spaced apart from each other. The touch sensor 100 may include two elastic layers 140. Each sub-electrode may be provided with a through hole. Each elastic layer 140 may be provided on the substrate 110 through the through hole on each of the sub-electrodes to support the second electrode 130. Along a deformation direction of the elastic layer 140, a projection area of the second electrode 130 may be greater than the projection area of the elastic layer 140, and the projection areas of the first electrode 120 and the second electrode 130 have an overlapping region to ensure that the first electrode 120 and the second electrode 130 may have a contact surface between them after the elastic layer 140 is compressed.

Further, the touch sensor 100 may also include electrode leads (not shown) to enable the touch sensor 100 to be connected to a circuit so that an electrical signal generated by the touch sensor 100 can be output. Specifically, in some embodiments, the sub-electrode 122 (or the sub-electrode 124) and the second electrode 130 may each be connected to an electrode lead to enable the touch sensor 100 to be in the disconnected state when the elastic layer 140 is in a natural state, and to enable the touch sensor 100 to be in the connected state when the elastic layer 140 is compressed. In some embodiments, the sub-electrode 122 and the sub-electrode 124 may each be connected to an electrode lead to enable the touch sensor 100 to be in the disconnected state when the elastic layer 140 is in the natural state and to enable the touch sensor 100 to be in the connected state when the elastic layer 140 is compressed. When the elastic layer 140 is in the natural state, the second electrode 130 and the first electrode 120 are not in contact, causing the touch sensor 100 to be in the disconnected state, as shown in FIG. 6A. When the touch sensor 100 is subjected to an external pressure (e.g., a user taps the second electrode 130), the elastic layer 140 may deform and be compressed. At this time, as the projections of the first electrode 120 and the second electrode 130 along the deformation direction of the elastic layer 140 have the overlapping region and at least a portion of the overlapping region is not covered by the elastic layer 140, the second electrode 130 may be in contact with the first electrode 120, leaving the touch sensor 100 in the connected state, as shown in FIG. 6B.

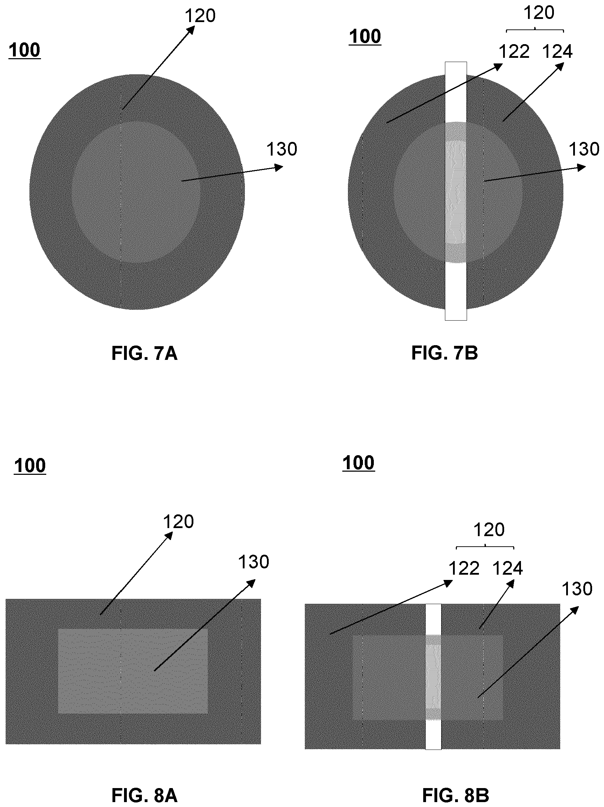

FIG. 7A is a top view illustrating an exemplary touch sensor according to some embodiments of the present disclosure. FIG. 7B is a top view illustrating an exemplary touch sensor according to some other embodiments of the present disclosure. FIG. 8A is a top view illustrating an exemplary touch sensor according to some other embodiments of the present disclosure. FIG. 8B is a top view illustrating an exemplary touch sensor according to some other embodiments of the present disclosure.

In some embodiments, the shape of the first electrode 120 and/or the second electrode 130 may be a regular shape such as a rectangle, a ring, a circle, a box, or any other irregular shape. For example, the shapes of the first electrode 120 and the second electrode 130 may both be circular, as shown in FIG. 7A. The elastic layer 140 may be circular and provided on the first electrode 120 to stably support the second electrode 130. For another example, as shown in FIG. 7B, the first electrode 120 is circular, and the overall shape of the second electrode 130 is also circular. The elastic layer 140 may be circular and disposed on both the first electrode 120 and the substrate 110 to stably support the second electrode 130. For another example, as shown in FIG. 8A, the first electrode 120 and the second electrode 130 may both be rectangular. The elastic layer 140 may be a rectangular ring and disposed on the first electrode 120 to stably support the second electrode 130. For another example, as shown in FIG. 8B, the first electrode 120 is rectangular, and the overall shape of the second electrode 130 is also rectangular. The elastic layer 140 may be the rectangular ring and disposed on both the first electrode 120 and the substrate 110 to stabilize support of the second electrode 130.

In some embodiments, the first electrode 120 may be an integral electrode or a split electrode. For example, the first electrode 120 may be a circular integral electrode, as shown in FIG. 7A. For another example, the first electrode 120 may be a split electrode with an overall circular shape, as shown in FIG. 7B. For another example, the first electrode 120 may be a rectangular-shaped overall electrode as shown in FIG. 8A. Further example, as shown in FIG. 8B, the first electrode 120 may be the split electrode that is overall rectangular.

The touch sensor 100 described in some embodiments of the present disclosure may improve the mounting adaptability of the touch sensor 100 by setting the touch sensor 100 (e.g., the first electrode 120 and/or the second electrode 130) in different shapes.

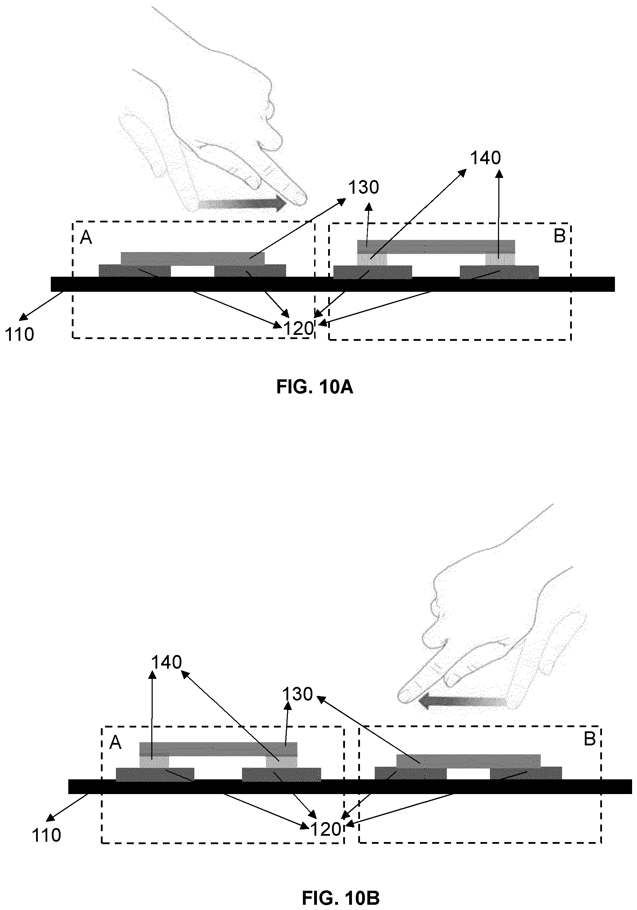

FIG. 9 is a block diagram illustrating a structure of an exemplary touch sensing device according to some embodiments of the present disclosure. FIG. 10A is a schematic diagram illustrating a state of an exemplary touch sensing device when a slide gesture slides to the right according to some embodiments of the present disclosure. FIG. 10B is a schematic diagram illustrating a state of an exemplary touch sensing device when a slide gesture slides to the left according to some embodiments of the present disclosure.

As shown in FIG. 9, a touch sensing device 900 may include two or more touch sensors 910, a power supply assembly 920, and a processor 930.

Each of the touch sensors 910 may be arranged at different positions of an interface to be detected. Each of the touch sensors 910 may be used to switch from a disconnected state to a connected state in response to a user applying a pressure, and to generate an electrical signal corresponding to a position of the touch sensor. The touch sensor 910 may include a substrate, a first electrode, a second electrode, and an elastic layer. The first electrode may be provided on the substrate. The elastic layer may be provided on the first electrode or the substrate, and the second electrode is provided on the elastic layer. When the elastic layer is in a natural state, the first electrode and the second electrode are not in contact, and the touch sensor is in the disconnected state. When the user applies a pressure to the touch sensor, the elastic layer undergoes a deformation, and the first electrode is in contact with the second electrode. The touch sensor switches from the disconnected state to the connected state and generates the electrical signal. For more descriptions of the touch sensor 910, please refer to elsewhere in the present disclosure, e.g., FIG. 1 and the descriptions, which is not repeated here.

The power supply assembly 920 may be used to supply power to the touch sensor 910.

The processor 930 may be used to determine a touch gesture of the user based on electrical signals corresponding to two or more touch sensors 910. In some embodiments, the touch gesture may include a tap gesture, a long press gesture, a slide gesture, etc.

In some embodiments, the touch sensing device 900 may also include a signal collector (not shown) to collect signal changes in a touch detection circuit when the touch sensors are disconnected or connected. In some embodiments, the signal collector may include a voltmeter, an ammeter, a resistance meter, etc., or a combination thereof. In embodiments of the present disclosure, the voltmeter is taken as an example of the signal collector for description.

In the embodiment of the present disclosure, as the touch sensors 910 in the touch sensing device 900 are distributed in different positions, different touch gestures of the user may cause the touch sensors 910 in different positions to be in different states (the disconnected state and the connected state), thereby generating different (e.g., different amplitude values, different times, etc.) detection signals (i.e., electrical signals). Further, the processor 930 may determine the touch gesture of the user based on positional information of the touch sensors, temporal information and/or amplitude value information of the collected electrical signals. For example, the processor 930 may determine the touch gesture of the user based on the position of each touch sensor 910 and the generation time of the corresponding electrical signal. Merely by way of example, when the signal collector detects that only a certain touch sensor generates the electrical signal (or the amplitude value of the detected electrical signal corresponds to the amplitude value of a certain touch sensor when it is in the connected state), the processor 930 may determine that the user is tapping the position corresponding to that touch sensor, i.e., that the touch gesture is the tap gesture. When the signal collector detects that only a certain touch sensor generates the electrical signal (or the amplitude value of the detected electrical signal corresponds to the amplitude value of a certain touch sensor when it is in the connected state) and a duration of the electrical signal exceeds a preset time (e.g., 0.5 seconds, 1 second, 2 seconds, etc.), the processor 930 may determine that the user is long pressing a position corresponding to that touch sensor, i.e., the touch gesture is the long press gesture. Within a preset time (e.g., 50 ms, 100 ms, 500 ms, etc.), when the signal collector detects that the plurality of touch sensors successively generates the electrical signals (or the amplitude value of the detected electrical signals change from one value to another), the processor 930 may determine that the touch gesture of the user is the slide gesture.

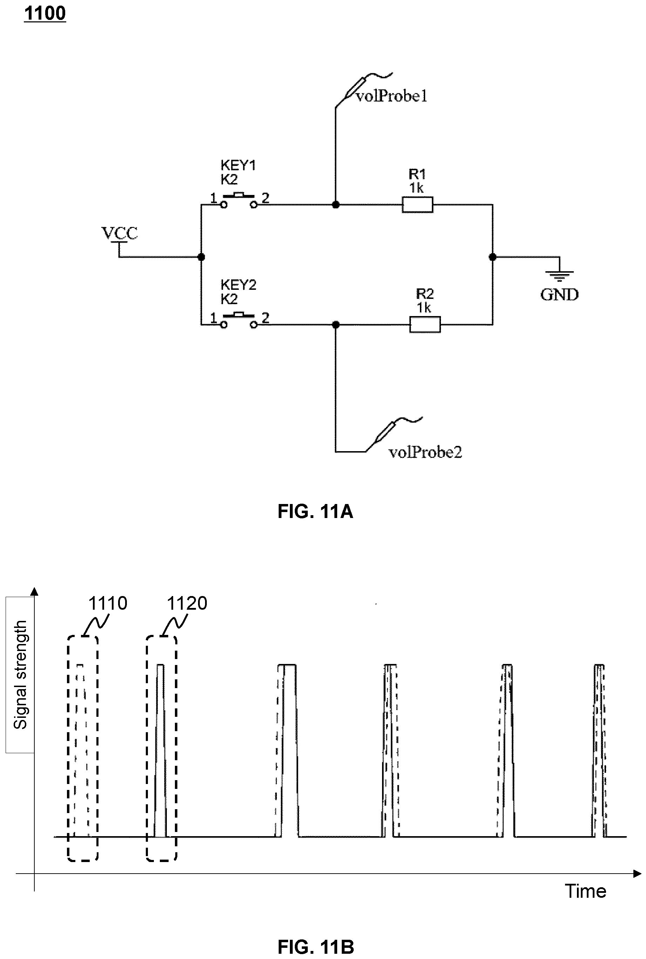

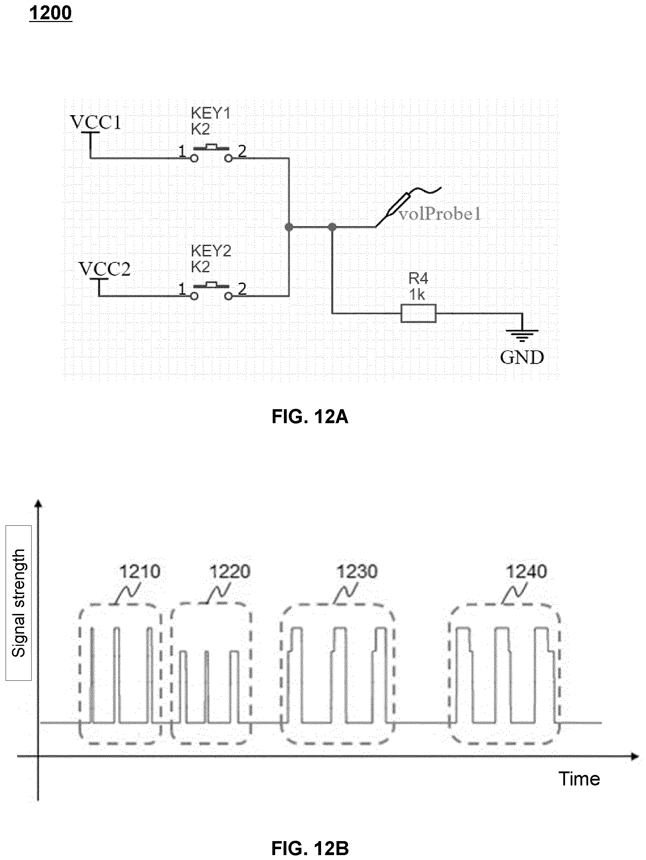

In some embodiments, by constructing different touch circuits (e.g., as shown in FIGs. 11A and 12A), it is possible to cause the touch sensors 910 at different positions to generate different (e.g., different amplitude values, different times, etc.) detection signals (i.e., electrical signals). For example, as shown in FIG. 11A, each touch sensor 910 in the touch sensing device 900 (or the touch detection circuit) may correspond to one signal collector. At this point, the electrical signals corresponding to the two or more touch sensors 910 may include the electrical signal corresponding to each touch sensor. For another example, as shown in FIG. 12A, the touch sensing device 900 (or the touch detection circuit) may only include one signal collector. At this time, the electrical signals corresponding to the two or more touch sensors 910 may be a composite signal including the electrical signal corresponding to each touch sensor separately. For more detailed descriptions of the touch detection circuit, please refer to FIGs. 11A-11B and FIGs. 12A-12B.

Further, the processor 930 may determine a slide direction of the slide gesture of the user based on a law of change of the collected electrical signal over time. For example, as shown in FIG. 10A, a touch sensor A is provided on a left side of a touch sensor B. When the touch gesture is a slide gesture to the right, the user's finger may successively pass the touch sensor A and the touch sensor B in the touch sensing device 900, which in turn causes the deformation of the elastic layers 140 of the touch sensor A and the touch sensor B, thereby sequentially causing the first electrodes 120 and the second electrodes 130 of the touch sensor A and the touch sensor B to contact, thus causing the touch sensor A and the touch sensor B to sequentially switch from the disconnected state to the connected state, and generating respective corresponding electrical signals. At this time, the touch sensor A generates the electrical signal first (or the generated electrical signal corresponds to a first amplitude value), and the touch sensor B generates the electrical signal later (or the generated electrical signal corresponds to a second amplitude value). Similarly, as shown in FIG. 10B, when the touch gesture is the slide gesture to the left, the user's finger may pass the touch sensor B and the touch sensor A in the touch sensing device 900 in succession. At this time, the touch sensor B generates the electrical signal first (or the generated electrical signal corresponds to the second amplitude value), and the touch sensor A generates the electrical signal later (or the generated electrical signal corresponds to the first amplitude value). Therefore, if the signal collector successively collects the electrical signals from the touch sensor A and the touch sensor B, and the electrical signal generated by the touch sensor A precedes the electrical signal generated by the touch sensor B (or the amplitude value of the generated electrical signal changes from the first amplitude value to the second amplitude value), the processor 930 may determine that the user slides to the right. Similarly, if the signal collector successively collects the electrical signals of the touch sensor A and the touch sensor B, and the electrical signal generated by the touch sensor B precedes the electrical signal generated by the touch sensor A (or the amplitude value of the generated electrical signal is changed from the second amplitude value to the first amplitude value), the processor 930 may determine that the user slides to the left.

FIG. 11A is a schematic diagram illustrating an exemplary touch detection circuit of a touch sensing device according to some embodiments of the present disclosure. FIG. 11B is an electrical signal detected by the touch detection circuit in FIG. 11A.

As shown in FIG. 11A, a touch detection circuit 1100 of the touch sensing device 900 may include a touch sensor KEY1, a touch sensor KEY2, a power supply VCC, a resistor R1, a resistor R2, a voltmeter volProbe1, and a voltmeter volProbe2. The touch sensor KEY1 and the touch sensor KEY2 may be provided in parallel in the touch detection circuit 1100. Each of the touch sensors may correspond to a detection sub-circuit. At least one resistor may be provided in each detection sub-circuit. Specifically, one end of the touch sensor KEY1 and one end of the touch sensor KEY2 may be connected to the power supply VCC, and the other ends of the touch sensors KEY1 and KEY2 may be connected to one end of the resistor R1 and the resistor R2, respectively. The other ends of the resistor R1 and the resistor R2 may be grounded.

In some embodiments, the resistances of the resistors in the individual detection sub-circuits may be the same or different. The voltmeter volProbe1 and the voltmeter volProbe2 may detect voltages of two ends of the resistor R1 and resistor R2, respectively. By detecting voltages (i.e., the electrical signals of the touch sensing device 900) at the two ends of the resistor R1 and the resistor R2, a state (e.g., a connected state and a disconnected state) of the touch sensor KEY1 and a state of the touch sensor KEY2 may be determined to determine a touch gesture of the user.

For example, when the user makes a tap gesture at a position corresponding to the touch sensor KEY1, the touch sensor KEY1 may switch from the disconnected state to the connected state, and then quickly return to the disconnected state from the connected state. The touch sensor KEY2 always remains in the disconnected state. At this time, the voltmeter volProbe1 of the detection sub-circuit where the touch sensor KEY1 is located may detect the voltage signal (i.e., the voltage at the two ends of the resistor R1 increases) and then quickly return to 0 (i.e., the touch sensor KEY1 returns to the disconnected state), while the voltmeter volProbe2 of the detection sub-circuit where the touch sensor KEY2 is located does not detect the voltage signal (i.e., the touch sensor KEY2 always remains in the disconnected state). Similarly, when the user makes a tap gesture at the corresponding position of the touch sensor KEY2, the touch sensor KEY2 may switch from the disconnected state to the connected state, and then quickly restores to the disconnected state from the connected state. The touch sensor KEY1 always stays in the disconnected state. At this time, the voltmeter volProbe2 in the detection sub-circuit where the touch sensor KEY2 is located may detect the voltage signal (i.e., the voltage at the two ends of the resistor R2 increases) and then quickly restore to 0 (i.e., the touch sensor KEY2 restore the disconnected state), while the voltmeter volProbe1 in the detection sub-circuit where the touch sensor KEY1 is located does not detect the voltage signal (i.e., the touch sensor KEY1 is always in the disconnected state). Thus, as shown in FIG. 11B, when the collected electrical signal is an electrical signal detected by the voltmeter volProbe1 (corresponding to a signal peak 1110), the processor 930 may determine that the user performs a tap operation at the position corresponding to the touch sensor KEY1. When the collected electrical signal is an electrical signal detected by the voltmeter volProbe2 (corresponding to a signal peak 1120), the processor 930 may determine that the user performs the tap operation at the position corresponding to the touch sensor KEY2.

For another example, when the user performs a long press gesture at a position corresponding to the touch sensor KEY1, the touch sensor KEY1 may switch from the disconnected state to the connected state and remain for a certain period of time and then restore from the connected state to the disconnected state. The touch sensor KEY2 always remains in the disconnected state. At this time, the voltmeter volProbe1 of the detection sub-circuit where the touch sensor KEY1 is located may detect the voltage signal (i.e., the voltage at the two ends of the resistor R1 increases) and keep for a period of time and then return to 0 (i.e., the touch sensor KEY1 is restored to the disconnected state), while the voltmeter volProbe2 of the detection sub-circuit where the touch sensor KEY2 is located does not detect the voltage signal (i.e., the touch sensor KEY2 is kept in the disconnected state). Similarly, when the user makes a long press gesture at the position corresponding to the touch sensor KEY2, the touch sensor KEY2 may switch from the disconnected state to the connected state, and keep for a period of time and then restore from the connected state to the disconnected state. The touch sensor KEY1 always remains in the disconnected state. At this time, the voltmeter volProbe2 of the detection sub-circuit where the touch sensor KEY2 is located may detect the voltage signal (i.e., the voltage at the two ends of the resistor R2 increases) and keep for a period of time and then restore to 0 (i.e., the touch sensor KEY2 is restored to the disconnected state), while the voltmeter volProbe1 of the detection sub-circuit where the touch sensor KEY1 is located does not detect the voltage signal at all (i.e., the touch sensor KEY1 always remains in the disconnected state). Thus, when the collected electrical signal is the electrical signal detected by the voltmeter volProbe1 and the electrical signal is kept for a duration that exceeds a duration threshold (e.g., 0.5 seconds, 1 second, 2 seconds, etc.), the processor 930 may determine that the user performs the long press operation at the position corresponding to the touch sensor KEY1. When the collected electrical signal is the electrical signal detected by the voltmeter volProbe2 and the electrical signal is kept for a duration that exceeds the duration threshold, the processor 930 may determine that the user performs a long press operation at the position corresponding to the touch sensor KEY2.

As a further example, when the user slides from the position corresponding to the touch sensor KEY1 to the position corresponding to the touch sensor KEY2, the touch sensor KEY1 may switch from the disconnected state to the connected state, and quickly return from the connected state to the disconnected state. Then, the touch sensor KEY2 can switch from the disconnected state to the connected state, and quickly restore from the connected state to the disconnected state. At this time, the voltmeter volProbe1 of the detection sub-circuit where the touch sensor KEY1 is located may detect the voltage signal (i.e., the voltage at the ends of the resistor R1 increases) and quickly return to 0 (i.e., the touch sensor KEY1 returns to the disconnected state), and the voltmeter volProbe2 of the detection sub-circuit where the touch sensor KEY2 is located may also detect the voltage signal (i.e., the voltage at the ends of the resistor R2 increases) and quickly return to 0 (i.e., the touch sensor KEY2 returns to the disconnected state). The voltmeter volProbe2 of the detection sub-circuit where the touch sensor KEY2 is located may also detect the voltage signal (i.e. the voltage at the ends of the resistor R2 increases) and quickly return to 0 (i.e. the touch sensor KEY2 returns to the disconnected state). The time at which the voltmeter volProbe1 detects the electrical signal is before the time at which the voltmeter volProbe2 detects the electrical signal. Similarly, when the user slides from the position corresponding to the touch sensor KEY2 to the position corresponding to the touch sensor KEY1, the touch sensor KEY2 switches from the disconnected state to the connected state and quickly restore from the connected state to the disconnected state. Then the touch sensor KEY1 switches from the disconnected state to the connected state, and quickly restore from the connected state to the disconnected state. At this time, the voltmeter volProbe2 in the detection sub-circuit where the touch sensor KEY2 is located may detect the voltage signal (i.e., the voltage at the two ends of the resistor R2 increases) and quickly restore to 0 (i.e., the touch sensor KEY2 restores to the disconnected state), and the voltmeter volProbe1 in the detection sub-circuit where the touch sensor KEY1 is located may also detect the voltage signal (i.e., the voltage at the two ends of the resistor R1 increases) and quickly restore to 0 (i.e., the touch sensor KEY1 restores to the disconnected state). A time when the voltmeter volProbe2 detects the electrical signal is before a time when the voltmeter volProbe1 detects the electrical signal. Thus, when the collected electrical signal is the electrical signal detected by both the voltmeter volProbe1 and the voltmeter volProbe2, and the time at which the voltmeter volProbe1 detects the electrical signal is prior to the time at which the voltmeter volProbe2 detects the electrical signal by a preset duration (e.g., 50 ms, 100 ms, 500 ms, etc.), the processor 930 may determine that the user performs a slide gesture from the position corresponding to the touch sensor KEY1 to the position corresponding to the touch sensor KEY2. When the collected electrical signal is the electrical signal detected by both voltmeter volProbe1 and voltmeter volProbe2 and the time at which voltmeter volProbe2 detects the electrical signal is prior to the time at which voltmeter volProbe1 detects the electrical signal by a preset duration (e.g., 50 ms, 100 ms, 500 ms, etc.), the processor 930 may determine that the user performs a slide gesture from the position corresponding to the touch sensor KEY2 to the position corresponding to the touch sensor KEY1.

It is to be appreciated that, in some embodiments, no resistor (e.g., the resistor R1 or the resistor R2) may be provided in the detection sub-circuit of the touch detection circuit 1100. By setting different materials (or conductivity) of the electrodes (including the first electrode and/or the second electrode) in the touch sensor KEY1 and the touch sensor KEY2, each detection sub-circuit corresponds to a different resistance value. The voltmeter volProbe1 and the voltmeter volProbe2 may detect a total voltage signal of each detection sub-circuit as the electrical signals of the touch sensing device 900 (i.e., the electrical signals corresponding to the two or more touch sensors 910), respectively.

For the touch sensing device described in some embodiments of the present disclosure, by adopting the touch detection circuit 1100, when an abnormality occurs to a touch sensor and/or a resistor in a certain detection sub-circuit, no effect is caused on the states of the touch sensors in other detection sub-circuits, which makes the structure more reliable. Additionally, the intensity of the detection signal of the touch sensing device may be adjusted by adjusting the resistance values of the resistors in the detection sub-circuits, so that no signal amplification circuit may be required. As a result, the structure of the touch sensing device is simpler, the cost of the touch sensing device is reduced, which is conducive to commercialization.

FIG. 12A is a schematic diagram illustrating an exemplary touch detection circuit of a touch sensing device according to some embodiments of the present disclosure. FIG. 12B is an electrical signal detected by the touch detection circuit in FIG. 12A.

As shown in FIG. 12A, a touch detection circuit 1200 of the touch sensing device 900 may include the touch sensor KEY1, the touch sensor KEY2, a power supply VCC1, a power supply VCC2, a resistor R4, and the voltmeter volProbe1. The touch sensor KEY1 and the touch sensor KEY2 may be provided in parallel in the touch detection circuit 1200. Each of the touch sensors may correspond to a detection sub-circuit. Specifically, one end of the touch sensor KEY1 and one end of the touch sensor KEY2 are connected to the power supply VCC1 and the power supply VCC2, respectively. The other end of the touch sensor KEY1 and the other end of the touch sensor KEY2 are connected to the resistor R4, and the other end of the resistor R4 may be grounded.

In some embodiments, power supply voltages of the power supply VCC1 and the power supply VCC2 may be the same or different. For example, when the power supply voltages of the power supply VCC1 and the power supply VCC2 are different, the total resistances of the detection sub-circuits corresponding to the touch sensors KEY1 and KEY2 may be the same or different. For another example, when the power supply voltages of the power supply VCC1 and the power supply VCC2 are the same, the total resistances of the detection sub-circuits corresponding to the touch sensors KEY1 and KEY2 may be different. Thus, voltages at two ends of the resistor R4 are different when the touch sensor KEY1 are the touch sensor KEY2 are in connected states. The voltmeter volProbe1 may detect the voltage at the two ends of the resistor R4. By detecting the voltage at the two ends of the resistor R4 (i.e., the electrical signal of the touch sensing device 900), the states (e.g., the connected state and a disconnected state) of the touch sensor KEY1 and the touch sensor KEY2 may be determined to determine a touch gesture of a user.

For example, when the user makes a tap gesture at a position corresponding to the touch sensor KEY1, the touch sensor KEY1 may switch from the disconnected state to the connected state, and then quickly restore to the disconnected state from the connected state. The touch sensor KEY2 always remains in the disconnected state. At this point, the voltmeter volProbe1 may detect a voltage signal whose amplitude value is a first amplitude value, which then quickly restores to 0 (i.e., the touch sensor KEY1 restores to the disconnected state). The first amplitude value may correspond to a voltage value at the two ends of the resistor R4 when the touch sensor KEY1 is in the connected state and the touch sensor KEY2 is in the disconnected state. Similarly, when the user makes the tap gesture at the position corresponding to the touch sensor KEY2, the touch sensor KEY2 may switch from the disconnected state to the connected state, and then quickly restore from the connected state to the disconnected state. The touch sensor KEY1 always remains in the disconnected state. At this point, the voltmeter volProbe1 may detect the voltage signal whose amplitude value is the second amplitude value, which then quickly restores to 0 (i.e., the touch sensor KEY2 restores to the disconnected state). The second amplitude value may correspond to the voltage value at the two ends of the resistor R4 when the touch sensor KEY2 is in the connected state and the touch sensor KEY1 is in the disconnected state. Thus, as shown in FIG. 12B, when the amplitude value of the collected electrical signal is equal to the first amplitude value (corresponding to the amplitude value of a signal peak in a dotted circle 1210), the processor 930 may determine that the user has performed a tap operation at the position corresponding to the touch sensor KEY1. When the amplitude value of the collected electrical signal is equal to the second amplitude value (corresponding to the amplitude value of the signal peak in the dotted circle1220), the processor 930 may determine that the user performs the tap operation at the position corresponding to the touch sensor KEY2.

For another example, when the user makes a long pressing gesture at the position corresponding to the touch sensor KEY1, the touch sensor KEY1 may switch from the disconnected state to the connected state, and keep for a period of time and then restore from the connected state to the disconnected state. The touch sensor KEY2 may always remain in the disconnected state. At this point, the voltmeter volProbe1 may detect the voltage signal whose amplitude value is equal to the first amplitude value and hold for a duration that exceeds a duration threshold (e.g., 0.5 seconds, 1 second, 2 seconds, etc.). Similarly, when the user makes the long press gesture at the position corresponding to the touch sensor KEY2, the touch sensor KEY2 may switch from the disconnected state to the connected state, and hold for a period of time and then restore from the connected state to the disconnected state. The touch sensor KEY1 always remains in the disconnected state. At this time, the voltmeter volProbe1 may detect the voltage signal whose amplitude value is equal to the second amplitude value and hold for a period of time exceeding the duration threshold. Thus, when the amplitude value of the collected electrical signal is equal to the first amplitude value and a holding duration of the electrical signal exceeds the duration threshold, the processor 930 may determine that the user performs the long press operation at the position corresponding to the touch sensor KEY1. When the amplitude value of the collected electrical signal is equal to the second amplitude value and the electrical signal is held for a duration that exceeds the duration threshold, the processor 930 may determine that the user performs the long press operation at the position corresponding to the touch sensor KEY2.

For another example, when the user slides from the position corresponding to the touch sensor KEY1 to the position corresponding to the touch sensor KEY2, the touch sensor KEY1 may switch from the disconnected state to the connected state, and quickly restore from the connected state to the disconnected state. The touch sensor KEY2 may switch from the disconnected state to the connected state, and quickly restore from the connected state to the disconnected state. At this time, the amplitude value of the electrical signal detected by the voltmeter volProbe1 rapidly (e.g., within 50 ms, 100 ms, 500 ms, etc.) changes from the first amplitude value to the second amplitude value. Similarly, when the user slides from the position corresponding to the touch sensor KEY2 to the position corresponding to the touch sensor KEY1, the touch sensor KEY2 may switch from the disconnected state to the connected state and quickly restore from the connected state to the disconnected state. Then the touch sensor KEY1 may switch from the disconnected state to the connected state, and quickly restore from the connected state to the disconnected state. At this time, the amplitude value of the electrical signal detected by the voltmeter volProbe1 rapidly changes from the second amplitude value to the first amplitude value. Thus, as shown in FIG. 12B, when the amplitude value of the collected electrical signal rapidly changes from the first amplitude value to the second amplitude value (corresponding to the change in the amplitude value of the signal in a dotted circle 1230), the processor 930 may determine that the user performs a slide gesture from the position corresponding to the touch sensor KEY1 to the position corresponding to the touch sensor KEY2. When the amplitude value of the collected electrical signal rapidly changes from the second amplitude value to the first amplitude value (corresponding to the change in the amplitude value of the signal in a dotted circle 1240), the processor 930 may determine that the user performs the slide gesture from the position corresponding to the touch sensor KEY2 to the position corresponding to the touch sensor KEY1.

For the touch sensing device described in some embodiments of the present disclosure, by adopting the touch detection circuit 1200, detection and computation resources may be effectively saved, so as to reduce a cost of the touch sensing device, and facilitate commercialization.

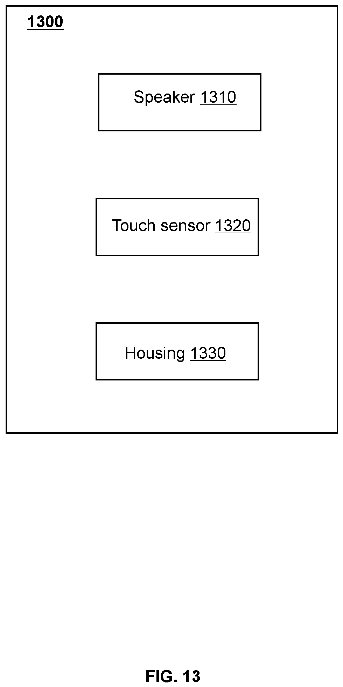

FIG. 13 is a block diagram illustrating a structure of an exemplary earphone according to some embodiments of the present disclosure. As shown in FIG. 13, an earphone 1300 may include a speaker 1310, a touch sensor 1320, and a housing 1330.

The speaker 1310 may be used to generate a sound signal.

The touch sensor 1320 may be used to switch from a disconnected state to a connected state in response to a pressure applied by a user and generate a corresponding electrical signal. The touch sensor 1320 may include a substrate, a first electrode, a second electrode, and an elastic layer. The first electrode may be provided on the substrate. The elastic layer may be provided on the first electrode or the substrate, and the second electrode is provided on the elastic layer. When the elastic layer is in a natural state, the first electrode and the second electrode are not in contact, and the touch sensor is in the disconnected state; when the user applies a pressure to the touch sensor, the elastic layer deforms, the first electrode comes into contact with the second electrode, and the touch sensor switches from the disconnected state to the connected state and generates the electrical signal. For more descriptions of the touch sensor 910, please refer to elsewhere in the present disclosure, e.g., in FIG. 1 and the descriptions, which are not repeated here.

The housing 1330 may be used to hold the speaker 1310 and the touch sensor 1320.

In some embodiments, the housing 1330 may include a contact surface. The contact surface is used to come into contact with a user's face when the user is wearing the earphone 1300, and at least a portion of the touch sensor 1320 is provided on the contact surface. When the user wears the earphone 1300, a pressure of the contact surface may cause the elastic layer in the touch sensor 1320 to deform, which in turn causes the first electrode thereof to come into contact with the second electrode, and generates the electrical signal. A processor (not shown) may determine that the user finishes wearing based on the electrical signal. Further, the processor may control one or more electronic components of the earphone 1300 (e.g., a Bluetooth module, a battery, etc.) to enter an operation state. For example, the processor may control the earphone 1300 to turn on and play music. When the earphone 1300 is unworn, the pressure on the contact surface disappears, the touch sensor 1320 is in a disconnected state, and the processor may determine that the user is unworn in response to the disconnected state of the touch sensor 1320. Further, the processor may control the one or more electronic components of the earphone 1300 (e.g., the Bluetooth module, the battery, etc.) to enter a standby state.

The earphone (e.g., a TWS headphone) described in some embodiments of the present disclosure may be used for detection of the wearing or the non-wearing of the earphone by providing at least a portion of the touch sensor 1320 on one or more contact surfaces of the headphone 1300 with a human body.

Beneficial effects that may be brought about by the touch sensor, the touch sensing device, and the earphone described in some embodiments of the present disclosure include, but are not limited to: (1) the touch sensor has a simple structure and a strong anti-interference ability, which can realize the effect of a digital circuit in an analog circuit; (2) the adjustment of the sensitivity of the touch sensor may be realized by adjusting a distance between the first electrode and the second electrode when the elastic layer is in a natural state, and the adjustment is simple and convenient; (3) by reducing the distance between the first electrode and the second electrode when the elastic layer in the touch sensor is in the natural state, a high sensitivity sensing is realized; (4) by setting the touch sensor into different shapes, a mounting adaptability of the touch sensor 100 is improved; (5) the touch sensor may be conveniently adhered to a target surface, and is highly scalable; (6) the touch sensor has a very low cost, which is conducive to commercialization; (7) the touch sensor may also be used as an electrical switch, so as to achieve an effect of no protrusion on the surface of the structure, or to hide the switch.

The basic concepts have been described above, and it will be apparent to those skilled in the art that the foregoing detailed disclosure serves only as an example and does not constitute a limitation of the present disclosure. Although not explicitly stated here, those skilled in the art may make various modifications, improvements and amendments to the present disclosure. These alterations, improvements, and modifications are intended to be suggested by the present disclosure, and are within the spirit and scope of the exemplary embodiments of the present disclosure.

## Claims

1. A touch sensor comprising:
a substrate;
a first electrode and a second electrode, wherein the first electrode is disposed on the substrate; and
an elastic layer disposed on the first electrode or the substrate, wherein the second electrode is disposed on the elastic layer, wherein
when the elastic layer is in a natural state, the first electrode and the second electrode are not in contact, and the touch sensor is in a disconnected state; and
when a user applies a pressure to the touch sensor, the elastic layer deforms, the first electrode comes into contact with the second electrode, and
the touch sensor switches from the disconnected state to a connected state
and generates an electrical signal.

2. The touch sensor of claim 1, wherein a distance between the first electrode and the second electrode is in a range of 50 nm-1 mm when the elastic layer is in the natural state.

3. The touch sensor of claim 1, wherein in a deformation direction of the elastic layer, a thickness of the touch sensor is no more than 1 mm.

4. The touch sensor of claim 1, wherein in a deformation direction of the elastic layer, projections of the first electrode and the second electrode have an overlapping region, and at least a portion of the overlapping region is not covered by the elastic layer.

5. The touch sensor of claim 1, wherein the first electrode is an integral electrode.

6. The touch sensor of claim 1, wherein the first electrode includes two or more sub-electrodes spaced apart from each other.

7. The touch sensor of claim 1, wherein a thickness of the elastic layer in the natural state is in a range of 50 nm-1 mm, and an elastic coefficient of the elastic layer is in a range of 200 GPa-1 kPa.

8. The touch sensor of claim 1, further including:
a protective layer for encapsulating the substrate, the first electrode, the second electrode, and the elastic layer.

9. A touch sensing device including:
two or more touch sensors, wherein each touch sensor is configured to switch from a disconnected state to a connected state to generate an electrical signal in response to a pressure applied by a user;
a power supply assembly configured to supply power to the two or more touch sensors; and
a processor configured to determine a touch gesture of the user based on at least one electrical signal corresponding to the two or more touch sensors, wherein
each touch sensor includes:
a substrate;
a first electrode and a second electrode, wherein the first electrode is disposed on the substrate; and
an elastic layer disposed on the first electrode or the substrate, wherein the second electrode is disposed on the elastic layer, wherein
when the elastic layer is in a natural state, the first electrode and the second electrode are not in contact, and the touch sensor is in the disconnected state;
when the user applies the pressure to the touch sensor, the elastic layer deforms, the first electrode comes into contact with the second electrode, and the touch sensor switches from the disconnected state to the connected state and generates the electrical signal.

10. The touch sensing device of claim 9, wherein the touch gesture includes a tap gesture, a long press gesture, or a slide gesture.

11. The touch sensing device of claim 10, wherein the at least one electrical signal corresponding to the two or more touch sensors includes the electrical signal corresponding to each touch sensor, and the determining the touch gesture of the user based on the at least one electrical signal corresponding to the two or more touch sensors includes:
determining the slide gesture and a slide direction of the user based on a position of each touch sensor and a signal time of the electrical signal corresponding to each touch sensor.

12. The touch sensing device of claim 10, wherein the at least one electrical signal corresponding to the two or more touch sensors includes a composite signal of the electrical signals of the two or more touch sensors, and the determining the touch gesture of the user based on the at least one electrical signal corresponding to the two or more touch sensors includes:
determining the slide gesture and a slide direction of the user based on an amplitude of the composite signal.

13. The touch sensing device of claim 12, wherein the two or more touch sensors are disposed in parallel in a detection circuit, and each touch sensor corresponds to a detection sub-circuit, wherein
a resistance value of a resistor set in the detection sub-circuit corresponding to each touch sensor is different,
conductivities of the first electrode and the second electrode corresponding to different detection sub-circuits are different, or
different detection sub-circuits correspond to different supply voltages.

14. An earphone comprising:
a speaker configured to generate a sound signal;
at least one touch sensor; and
a housing for carrying the speaker and the at least one touch sensor, wherein
each touch sensor includes:
a substrate;
a first electrode and a second electrode, wherein the first electrode is disposed on the substrate; and
an elastic layer disposed on the first electrode or the substrate, wherein the second electrode is disposed on the elastic layer, wherein
when the elastic layer is in a natural state, the first electrode and the second electrode are not in contact, and the touch sensor is in the disconnected state;
when the user applies a pressure to the touch sensor, the elastic layer deforms, the first electrode comes into contact with the second electrode, and the touch sensor switches from the disconnected state to a connected state and generates an electrical signal.

15. The earphone of claim 14, wherein the housing includes a contact surface, when a user is wearing the earphone, the contact surface is configured to come into contact with the user's face, and at least a portion of the at least one touch sensor is disposed on the contact surface.

16. The earphone of claim 14, wherein in a deformation direction of the elastic layer, a thickness of the at least one touch sensor is no greater than 1 mm.

17. The earphone of claim 14, wherein in a deformation direction of the elastic layer, projections of the first electrode and the second electrode have an overlapping region, and at least a portion of the overlapping region is not covered by the elastic layer.

18. The earphone of claim 14, wherein the first electrode is an integral electrode.

19. The earphone of claim 14, wherein the first electrode includes two or more sub-electrodes spaced apart from each other.

20. The earphone of claim 14, wherein a thickness of the elastic layer in the natural state is in a range of 50 nm-1 mm, and an elastic coefficient of the elastic layer is in a range of 200 GPa-1 kPa.
